# EUROPÄISCHE PATENTSCHRIFT

(11) **EP 0 557 545 B1**
(45) Veröffentlichungstag und Bekanntmachung des Hinweises auf die Patenterteilung: **19.10.1994**
(21) Anmeldenummer: 92103183.7
(22) Anmeldetag: 25.02.1992
(51) Int. Cl.: H05K 9/00

(54) **Gehäuse für die elektrische Nachrichtentechnik**
Housing for electrical communication apparatus
Boîtier pour la technique électrique des communications

(43) Veröffentlichungstag der Anmeldung: 01.09.1993
(73) Patentinhaber: SIEMENS AKTIENGESELLSCHAFT, 80333 München (DE)
(72) Erfinder: Meschenmoser, Friedrich, W-8011 Neukeferloh (DE); Stögmüller, Rupert, W-8000 München 83 (DE)

(56) Entgegenhaltungen:
- EP-A- 0 306 694
- EP-A- 0 424 606
- DE-U- 7 208 393
- DE-U- 7 525 506
- DE-U- 9 109 072

## Beschreibung

Die Erfindung betrifft ein Gehäuse für die elektrische Nachrichtentechnik, bestehend aus einer elektrisch leitfähigen unteren und einer elektrisch leitfähigen oberen Gehäuseschale, wobei beide Gehäuseschalen durch Kammerwände in deckungsgleiche Kammern unterteilt sind, und zwischen den beiden Gehäuseschalen eine sich über alle Kammern erstreckende Platine angeordnet ist.

Ein derart aufgebautes Gehäuse ist z. B. aus dem deutschen Gebrauchsmuster DE-U- 91 09 072 bekannt. Bei diesem bekannten Gehäuse weist die Leiterplatte Masseleiterbahnstreifen auf, die an den jeweiligen Konturen der Wannen des Chassis verlaufen und nach dem Zusammenbau auf diesen Konturen kontaktgebend aufliegen. Bei größeren Gehäusen dieser Art mit nur einer Platine ist eine Kontaktierung über die gesamte Länge der Masseleiterbahnstreifen nicht mehr gewährleistet, so daß eine ausreichende Abschirmung nicht mehr gegeben ist. Die schlechte Kontaktierung bei großen Platinen ergibt sich aufgrund der bestehenden Fertigungstoleranzen. Um eine sichere Kontaktierung zu erreichen, müßte man mit geringsten Fertigungstoleranzen arbeiten, bzw. eine Vielzahl von eng benachbarten Schraubverbindungen vorsehen. Beides ist sehr aufwendig und daher nicht erwünscht.

Aufgabe der vorliegenden Erfindung ist es, ein Gehäuse der eingangs genannten Art so zu gestalten, daß auch bei größeren Gehäusen mit nur einer Platine ohne großen Aufwand eine zuverlässige Schirmung erreicht wird.

Diese Aufgabe wird erfindungsgemäß für ein Gehäuse der oben genannten Art dadurch gelöst, daß die äußeren und inneren Kammerwände der unteren Gehäuseschale nach oben hin durch Nuten begrenzt sind, in welche Dichtschnüre eingelegt sind, daß die Platine mit Kontaktstreifen versehen ist, deren Verlauf den Konturen der Kammern entspricht, und daß die Kontaktstreifen aus Metallstreifen bestehen, bei welchen abwechselnd Kontaktfedern schräg nach oben und spitze Stifte senkrecht nach unten abgebogen sind.

Durch die Verwendung von Dichtschnüren in Verbindung mit den spitzen Stiften unterhalb der Platine und der Verwendung von Kontaktfedern auf der Oberseite der Platine in jeweils kurzen Abständen werden vorhandene Fertigungstoleranzen vollständig ausgeglichen, so daß auch bei hohen Frequenzen eine zuverlässige Schirmung trotz gegebener Fertigungstoleranzen zwischen den beiden Gehäuseschalen und der Platine gewährleistet ist.

Eine zweckmäßige Weiterbildung des erfindungsgemäßen Gehäuses ist dadurch gekennzeichnet, daß die Kontaktstreifen mit den Stiften in Bohrungen der Platine derart eingelötet sind, daß sich an den auf der Unterseite der Platine herausragenden Spitzen der Stifte Zinnkegel ausbilden.

Auf diese Weise wird die Kontaktfläche zwischen den Stiften und der Dichtschnur vergrößert, gleichzeitig wird durch die keglige Form eine Zerstörung der Dichtschnur, welche zu einer schlechten Kontaktierung führen könnte, vermieden.

Nachfolgend soll die Erfindung anhand eines in der Zeichnung dargestellten Ausführungsbeispiels näher beschrieben werden.

Es zeigen
Figur 1 eine Explosionsdarstellung eines Gehäuses gemäß der vorliegenden Erfindung,
Figur 2 einen Schnitt durch eine Gehäusewand, und
Figur 3 eine Detaildarstellung eines Kontaktstreifens gemäß der vorliegenden Erfindung.

Das erfindungsgemäße Gehäuse besteht aus einer unteren Gehäuseschale 1 und einer oberen Gehäuseschale 2, zwischen denen eine Platine 3 angeordnet ist, welche beidseitig bestückt sein kann.

Sowohl die untere Gehäuseschale 1 als auch die obere Gehäuseschale 2 sind durch Kammerwände 5 in einzelne Kammern 4 unterteilt, deren Größe und Anordnung sich nach den auf der Platine befindlichen Baugruppen richtet und wie diese gegeneinander abgeschirmt sein müssen. Die Kammerwände 5 der unteren Gehäuseschale 1 weisen nach oben hin offene Nuten 7 auf, in welche Dichtschnüre 6 gelegt sind. Derartige Dichtschnüre 6 sind allgemein bekannt. Hierbei handelt es sich entweder um eine leitfähige Dichtschnur aus einem Silikonmaterial mit eingelagerten leitenden Partikeln oder um eine Dichtschnur mit einem außenliegenden Metallgeflecht. Die Gehäuseschalen 1 und 2 bestehen aus einem leitfähigen Material, z. B. aus Aluminium oder einer Magnesiumlegierung. Bei dem hier dargestellten Ausführungsbeispiel sind die nicht gezeigten Kammerwände der oberen Gehäuseschale 2 dünner als die Kammerwände 5 der unteren Gehäuseschale 1, so daß diese zu schmal sind, um an ihren oberen Kanten Nuten für die Dichtschnüre vorzusehen.

Die Platine ist mit Kontaktstreifen versehen, deren Verlauf den Konturen der deckungsgleichen Kammern 4 der beiden Gehäuseschalen 1 und 2 entspricht. Der Aufbau der Kontaktstreifen ergibt sich aus Figur 3. Bei dem hier dargestellten Kontaktstreifen ist jeweils abwechselnd ein spitzer Stift senkrecht nach unten gebogen und eine Kontaktfeder schräg nach oben abgebogen. Die Kontaktfeder ist an ihrem freien Ende nochmals abgewinkelt, um ein gutes Entlanggleiten an den aufzusetzenden Kammerwänden zu ermöglichen. An den Stellen, an welchen die Kontaktstreifen angebracht werden sollen, ist die Platine mit Bohrungen versehen, durch welche die Stifte der Kontaktstreifen hindurchgesteckt werden. Auf der Unterseite der Platine werden diese Stifte derart verlötet, daß sich um die herausragenden Spitzen der Stifte Zinnkegel ausbilden. Auf diese Weise wird jeweils ein großflächiger Kontakt mit der Dichtschnur erreicht und gleichzeitig eine mögliche Zerstörung der Dichtschnur durch die Spitzen verhindert.

Aufgrund der Verwendung von Dichtschnüre in Verbindung mit kegelförmigen Kontakten auf der Unterseite der Platine und Kontaktfedern auf der Oberseite der Platine können Fertigungstoleranzen leicht ausgeglichen werden, so daß sich auch bei gegebenen größeren Fertigungstoleranzen eine sichere Abschirmung erreichen läßt. Dabei kann der Abstand zwischen den Kontaktfedern bzw. den Stiften je nach Höhe der Anforderungen, d. h. je nach der Größe der geforderten HF-Dichtheit, variieren. Je größer die zu übertragenden Frequenzen sind, um so geringer müssen die Abstände gewählt werden.

In diesem Zusammenhang ist festzustellen, daß zur Erreichung einer vollkommenen Abschirmung bei vorgegebenen Fertigungstoleranzen sowohl oberhalb als auch unterhalb der Platine Dichtschnüre vorgesehen sein können, wenn der Aufbau der Kammerwände dies erlaubt. Ebenso ist es vorstellbar, daß sowohl auf der Oberseite als auch auf der Unterseite der Platine Metallstreifen mit Kontaktfedern vorgesehen sein können. Besonders vorteilhaft ist das Zusammenwirken von Kontaktfedern und Stiften in Verbindung mit Dichtschnüren.

Zur Erleichterung des Einlegens der Platine 3 in die untere Gehäuseschale 1 können Führungsstifte 11 in Verbindung mit Führungslöchern 12 innerhalb der Platine vorgesehen sein.

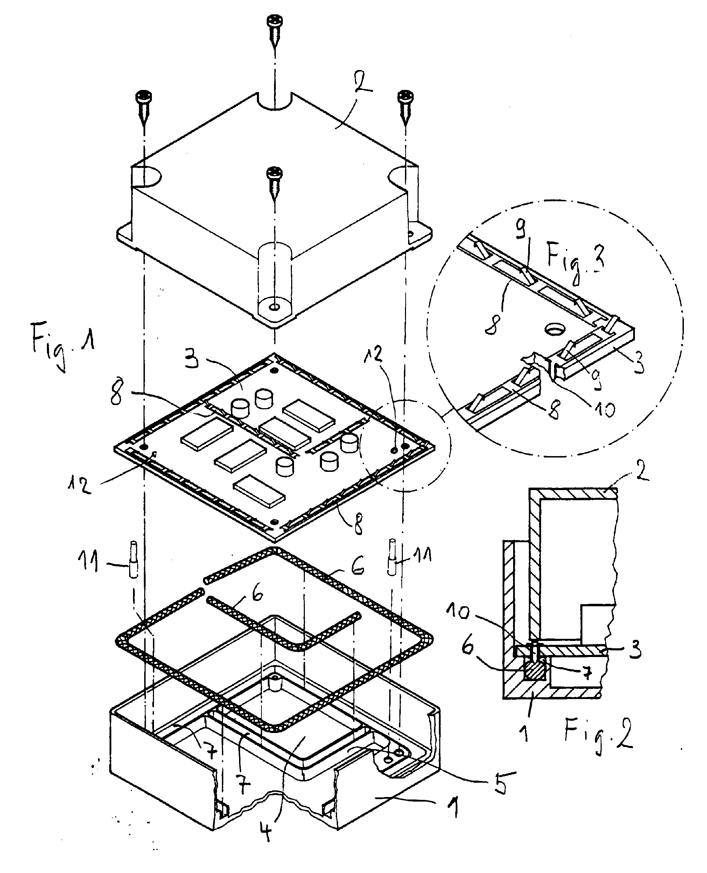

Die Figur 2 zeigt eine exemplarische Darstellung eines Schnitts durch die Gehäusewand eines Gehäuses gemäß der vorliegenden Erfindung, bei der eine Überlappung der Seitenteile der unteren Gehäuseschale 1 und der oberen Gehäuseschale 2 dargestellt ist. Hierzu ist festzustellen, daß diese Überlappung nicht notwendig ist, um eine bessere Schirmwirkung zu erreichen.

## Patentansprüche

1. Gehäuse für die elektrische Nachrichtentechnik, bestehend aus einer elektrisch leitfähigen unteren und einer elektrisch leitfähigen oberen Gehäuseschale, wobei beide Gehäuseschalen durch Kammerwände in deckungsgleiche Kammern unterteilt sind, und zwischen den beiden Gehäuseschalen eine sich über alle Kammern erstreckende Platine angeordnet ist, **dadurch** **gekennzeichnet**, daß die äußeren und inneren Kammerwände (5) der unteren Gehäuseschale (1) nach oben hin durch Nuten (7) begrenzt sind, in welche Dichtschnüre (6) eingelegt sind, daß die Platine (3) mit Kontaktstreifen (8) versehen ist, deren Verlauf den Konturen der Kammern (4) entspricht, und daß die Kontaktstreifen (8) aus Metallstreifen bestehen, bei welchen abwechselnd Kontaktfedern (9) schräg nach oben und spitze Kontaktstifte (10) senkrecht nach unten abgebogen sind.

2. Gehäuse nach Anspruch 1, **dadurch gekennzeichnet**, daß die Kontaktstreifen (8) mit den Kontaktstiften (10) in Bohrungen der Platine (3) derart eingelötet sind, daß sich an den auf der Unterseite der Platine herausragenden Spitzen der Kontaktstifte (10) Zinnkegel ausbilden.

## Claims

1. Housing for electrical communication apparatus, comprising an electroconductive lower and an electro-conductive upper housing shell, in which both housing shells are subdivided into congruent compartments by means of compartment walls, and a circuit board extending over all the compartments is arranged between the two housing shells, characterized in that the outer and inner compartment walls (5) of the lower housing shell (1) are delimited in an upward direction by grooves (7) into which sealing cords (6) are inserted, in that the circuit board (3) is provided with contact strips (8), the course of which follows the contours of the compartments (4), and in that the contact strips (8) comprise metal strips in which alternately contact springs (9) are bent obliquely upwards and pointed contact pins (10) are bent perpendicularly downwards.

2. Housing according to Claim 1, characterized in that the contact strips (8) with the contact pins (10) are soldered into holes of the circuit board (3) in such a way that tin cones form on the points of the contact pins (10) projecting from the underside of the circuit board.

## Revendications

1. Boîtier pour la technique électrique de transmission d'informations, constitué d'une coque inférieure électriquement conductrice et d'une coque supérieure électriquement conductrice, et dans lequel les deux coques du boîtier sont subdivisées par des parois, en des chambres coïncidant, et une platine, qui s'étend sur toutes les chambres, est disposée entre les deux coques du boîtier, caractérisé en ce que les parois extérieure et intérieure (5) des chambres de la coque inférieure (1) du boîtier sont limitées, vers le haut, par des rainures (7), dans lesquelles sont insérés des cordons d'étanchéité (6), que la platine (3) est pourvue de bandes de contact (8), dont la configuration correspond aux contours des chambres (4), et que les bandes de contact (8) sont constituées de bandes métalliques, dans lesquelles alternativement des ressorts de contact (9) sont repliés obliquement vers le haut, et des tiges pointues de contact (10) sont repliées à angle droit vers le bas.

2. Boîtier suivant la revendication 1, caractérisé par le fait que les bandes de contact (8) sont fixées par brasage, aux tiges de contact (10), dans des perçages de la platine (3) de sorte que des cônes en étain sont formés sur les pointes des tiges de contact (10), qui font saillie sur la face inférieure de la platine.
